# EUROPEAN PATENT APPLICATION

(11) **EP 2 448 103 A2**
(43) Date of publication of application: **02.05.2012**
(21) Application number: 10792304.7
(22) Date of filing: 22.06.2010
(51) Int. Cl.: H02N 2/00, H02N 2/04

(54) **DOME-SHAPED PIEZOELECTRIC LINEAR MOTOR**

(30) Priority: 22.06.2009 KR 20090055687
(71) Applicant: Inova, Inc., Chungcheongbuk-do 365-802 (KR); Yun, Man Sun, Chungcheongbuk-do 360-182 (KR)
(72) Inventor: YUN, Man Sun, Chungcheongbuk-do 360-182 (KR)
(74) Representative: Finnie, Peter John
(86) International application number: PCT/KR2010/004027
(87) International publication number: WO 2010/151022

(57) **Abstract**

The present invention relates to a dome-shaped piezoelectric linear motor, and provides a piezoelectric linear motor having enhanced displacement using dome-shaped piezoelectric ceramic. A dome-shaped piezoelectric linear motor (DSPLM) comprises: a dome-shaped piezoelectric ceramic actuator which has two surfaces applied with different electrodes; a bar-shaped vibration shaft which is vertically fixed at the apex of the dome-shaped piezoelectric ceramic actuator; a cylinder-shaped mobile element which is inserted into the vibration shaft and moves linearly along the vibration shaft; and a ceramic restraining element which is fixed at a lower edge portion of the dome-shaped piezoelectric ceramic actuator. Therefore, the vibration displacement in the direction of the vibration shaft is increased when compared to the vibration displacement in the thickness direction of planar piezoelectric ceramic.

## Description

### [Technical Field]

The present invention relates to a piezoelectric linear motor which employs a dome-shaped piezoelectric ceramic actuator to provide enhanced vibration displacement as compared with a conventional disk-shaped piezoelectric ceramic actuator.

### [Background Art]

Piezoelectric motors are next generation motors based on piezoelectric effects of a piezoelectric ceramic actuator which generates vibration according to variation of voltage applied thereto.

Such a piezoelectric motor is a noiseless motor having an inaudible driving frequency of 20 kHz or more and is also called an ultrasound motor.

The piezoelectric motor has a generating force of 3kg · cm, a reaction time of 0.1 ms or less, a size 10 times smaller than typical electric motors, and an accuracy of 0.1 m or less.

Thus, the piezoelectric motor has been used for a wide range of applications which require high torque together with low speed for realizing zooming, auto-focusing and anti-tremor functions for digital cameras, for driving a pick-up lens of a CD/DVD-ROM drive, and the like.

Generally, the piezoelectric motor may be realized as a vibration transmission type such as a flexural wave type or a standing wave type.

However, the vibration transmission type piezoelectric motor undergoes difficulty in ensuring constant amplitude due to abrasion of a contact region upon continuous operation there.

To overcome such a drawback, a piezoelectric linear motor includes piezoelectric thick films bonded to both sides of a metal elastic body via a bonding agent and connected to each other in parallel to allow a mobile element mounted on a moving shaft to be linearly moved by flexural motion used as a drive source.

This piezoelectric motor is smaller than conventional piezoelectric motors and allows a relatively simple manufacturing process and fast operating speed. However, it is necessary to bond a separate metal elastic plate to a piezoelectric ceramic actuator in order to improve displacement of the actuator. As a result, there are problems of an increase in manufacturing costs and a complicated manufacturing process. Further, since the piezoelectric thick films have a thickness of 100 µm, this piezoelectric motor is vulnerable to impact, has low generating force, and undergoes separation of the metal elastic plate from the piezoelectric thick films due to vibration of the piezoelectric thick films.

Furthermore, since vibration displacement of the moving shaft and the mobile element is limited to a predetermined magnitude in the related art, this piezoelectric motor has a restricted application range.

### [Disclosure]

### [Technical Problem]

The present invention is directed to solving such problems of the related art and provides a dome-shaped piezoelectric linear motor which enables vibration displacement to be ensured without bonding a separate elastic plate to a piezoelectric ceramic actuator.

The present invention also provides a dome-shaped piezoelectric linear motor which provides improved linear vibration displacement and operation efficiency, and expands an application range thereof, as compared with a piezoelectric motor employing a disk-shaped piezoelectric ceramic actuator.

### [Technical Solution]

In accordance with one aspect of the invention, a dome-shaped piezoelectric linear motor (DSPLM) includes: a dome-shaped piezoelectric ceramic actuator having opposite sides to which different electrodes are applied; a bar-shaped vibration shaft vertically secured to an apex of the dome-shaped piezoelectric ceramic actuator; a cylindrical mobile element inserted into the vibration shaft and linearly moving along the vibration shaft; and a ceramic restraining element secured to a lower edge of the dome-shaped piezoelectric ceramic actuator.

The piezoelectric linear motor may further include a compressing member disposed on the mobile element to maintain a predetermined degree of friction in a contact region between the mobile element and the vibration shaft.

The ceramic restraining element may be integrally formed with the piezoelectric ceramic actuator.

The ceramic restraining element may be formed of a material having rigidity capable of restraining radial vibration of the piezoelectric ceramic actuator and having a similar coefficient of thermal expansion to the piezoelectric ceramic actuator.

The ceramic restraining element may have a disk shape or a ring shape.

The ceramic restraining element may be coupled to the piezoelectric ceramic actuator via a thermosetting bonding agent.

### [Advantageous Effects]

According to embodiments of the invention, the dome-shaped piezoelectric linear motor allows vibration displacement to be ensured through a dome-shaped piezoelectric ceramic actuator without a separate elastic plate, thereby reducing manufacturing costs through elimination of a process of attaching an elastic element.

Further, the dome-shaped piezoelectric linear motor according to the embodiments has improved vibration displacement, improved operation range, and generating force, as compared with a piezoelectric motor employing a disk-shaped piezoelectric ceramic actuator.

Therefore, the dome-shaped piezoelectric linear motor according to the embodiments of the invention expands the application range thereof.

### [Description of Drawings]

Fig. 1 is a picture of a dome-shaped piezoelectric linear motor (DSPLM).
Fig. 2 and Fig. 3 are a picture and a side sectional view of a dome-shaped piezoelectric linear motor (DSPLM) according to one embodiment of the present invention.
Fig. 4 is a three-dimensional diagram for analyzing the dome-shaped piezoelectric actuator according to the embodiment of the present invention.
Fig. 5 is a diagram for finite element analysis of the dome-shaped piezoelectric actuator according to the embodiment of the present invention.
Fig. 6 is a simulation graph of an impedance-frequency curve of a dome-shaped piezoelectric linear motor (DSPLM) according to a comparative example.
Fig. 7 is a simulation graph of an impedance-frequency curve of a dome-shaped piezoelectric linear motor (DSPLM) according to one embodiment of the present invention.
Fig. 8 shows results of ATILA three-dimensional simulation upon application of resonance frequency to the dome-shaped piezoelectric linear motor (DSPLM) according to the comparative example.
Fig. 9 shows results of ATILA three-dimensional simulation upon application of resonance frequency to the dome-shaped piezoelectric linear motor (DSPLM) according to the embodiment of the present invention.
Fig. 10 is a graph depicting maximum vibration and application voltage for one example of a dome-shaped piezoelectric linear motor (DSPLM) according to the present invention.
Fig. 11 is a simulation graph of an impedance-frequency curve of another example of a dome-shaped piezoelectric linear motor (DSPLM) according to the present invention.
Fig. 12 is a graph depicting variation of a mobile element according to the inertial principle of a dome-shaped piezoelectric linear motor (DSPLM) according to one embodiment of the present invention.
Fig. 13 is a graph depicting electric potential according to the variation of Fig. 12.
Fig. 14 shows an apparatus for measuring constant displacement with respect to one example of the dome-shaped piezoelectric linear motor (DSPLM) according to the present invention.
Fig. 15 is a graph depicting total variation upon application of resonance frequency to the one example of the dome-shaped piezoelectric linear motor (DSPLM) according to the embodiment of the present invention.

### [Mode for Invention]

A dome-shaped piezoelectric linear motor (DSPLM) according to one embodiment of the present invention includes: a dome-shaped piezoelectric ceramic actuator having opposite sides to which different electrodes are applied; a bar-shaped vibration shaft vertically secured to an apex of the dome-shaped piezoelectric ceramic actuator; a cylindrical mobile element inserted into the vibration shaft and linearly moving along the vibration shaft; and a ceramic restraining element secured to a lower edge of the dome-shaped piezoelectric ceramic actuator.

When the vibration shaft is moved, the mobile element is moved according to the moving direction of the vibration shaft in the case where inertia of the mobile element is lower than friction of the vibration shaft.

Further, a compressing member is provided to a contact region between the mobile element and the vibration shaft to maintain a predetermined degree of friction therebetween while allowing the restraining element to maximize displacement of the dome-shaped piezoelectric ceramic actuator.

According to this embodiment, the piezoelectric ceramic actuator has a dome-shape in order to improve displacement thereof. Such a piezoelectric motor is referred to as a dome-shaped piezoelectric linear motor (DSPLM) and will now be described with reference to the picture.

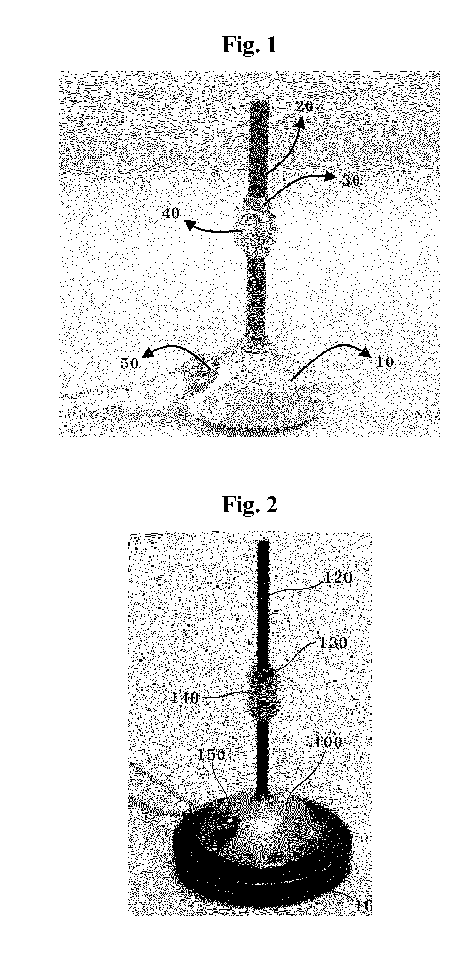

Fig. 1 is a picture of a dome-shaped piezoelectric linear motor (DSPLM).

Referring to Fig. 1, the dome-shaped piezoelectric linear motor includes a dome-shaped piezoelectric ceramic actuator 10, and a vibration shaft 20 disposed on the apex of the dome shape thereof. Here, the vibration shaft 20 may be secured to the apex of the dome shape via an epoxy bonding agent.

The vibration shaft 20 is provided at the middle thereof with a mobile element 30, and a silicone rubber member 40 is provided to an outer surface of the mobile element 30 to act as a compressing member.

The dome-shaped piezoelectric ceramic actuator is formed on the surface thereof with a solder 50 to which an electric wire for application of an electric field is connected.

When an electric filed U is applied to the piezoelectric ceramic actuator 10 through electrodes attached to upper and lower sides of the piezoelectric ceramic actuator 10, the piezoelectric ceramic actuator 10 is subjected to compression or extension by inverse piezoelectric effects.

That is, the piezoelectric ceramic actuator 10 according to the present invention is configured to have a dome shape having opposite sides to which different electrodes are applied, and vibrates in a way of protruding or depressing in the direction of the vibration shaft 20 according to variation of polarity of voltage applied to the opposite sides of the piezoelectric ceramic actuator 10.

In some embodiments, a restraining element is provided to an edge of the dome-shaped piezoelectric actuator, thereby maximizing effects of generating vibration at the apex of the dome-shaped piezoelectric actuator.

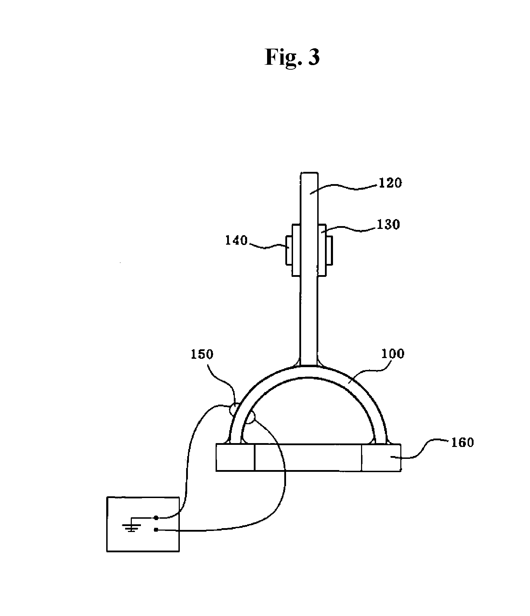

Fig. 2 and Fig. 3 are a picture and a side sectional view of a dome-shaped piezoelectric linear motor (DSPLM) according to one embodiment of the invention.

Referring to Fig. 2 and Fig. 3, the dome-shaped piezoelectric linear motor according to this embodiment includes a dome-shaped piezoelectric ceramic actuator 100 having opposite sides to which different electrodes are applied, and a bar-shaped vibration shaft 120 vertically secured to the apex of the dome-shaped piezoelectric ceramic actuator.

Further, a mobile element 130 has a cylindrical shape and is inserted into the vibration shaft 120. The mobile element 130 is provided on the outer surface thereof with a silicone rubber member 140 which acts as a compressing member for maintaining a predetermined degree of friction in a contact region between the mobile element 130 and the vibration shaft 120.

The piezoelectric motor further includes a power source for applying voltage to the piezoelectric ceramic actuator 100, an electric wire connecting the power source to opposite sides of the piezoelectric ceramic actuator 100, and solders 150 securing the electric wire to the opposite sides of the piezoelectric ceramic actuator 100.

The piezoelectric motor further includes a restraining element 160 secured to a lower edge of the dome-shaped piezoelectric ceramic actuator.

Here, the restraining element 160 is integrally secured to the piezoelectric ceramic actuator 100 via a thermosetting bonding agent. Further, the restraining element may have a disc shape or ring-shape cross-section. According to the present invention, the restraining element 160 maximizes displacement near the apex of the dome-shaped piezoelectric ceramic actuator.

In addition, the restraining element 160 may be formed of a material having rigidity capable of restraining radial vibration of the piezoelectric ceramic actuator 100 and having a similar coefficient of thermal expansion to the piezoelectric ceramic actuator. Further, the restraining element 160 is integrally coupled with the piezoelectric ceramic actuator by the thermosetting bonding agent such as an epoxy bonding agent. In this case, any thermosetting bonding agent may be used so long as the restraining element 160 is prevented from being broken thereby during heat hardening.

Next, the principle of generating vibration in the dome-shaped piezoelectric ceramic actuator (or the principle of generating vibration displacement) and effects of the restraining element according to the embodiment will be described with reference to the accompanying drawings.

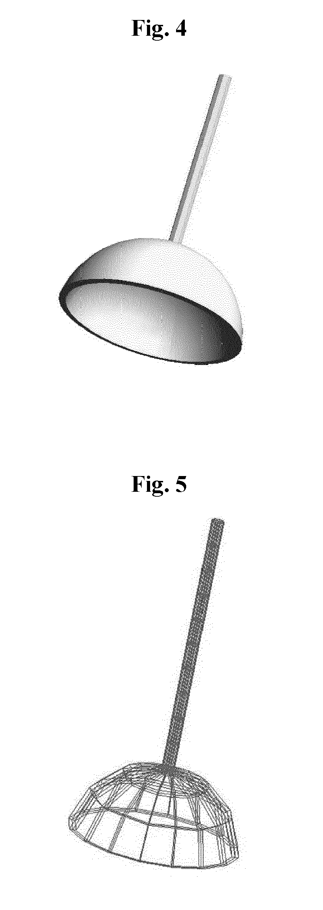

Fig. 4 is a three-dimensional diagram for analyzing the dome-shaped piezoelectric actuator according to the embodiment of the present invention, and Fig. 5 is a diagram for finite element analysis of the dome-shaped piezoelectric actuator according to the embodiment of the present invention.

Referring to Fig. 4 and Fig. 5, the direction of force applied to the dome-shaped piezoelectric ceramic motor can be schematically seen. Specifically, when the apex portion of the piezoelectric ceramic actuator constituting the piezoelectric ceramic motor contracts towards the vibration shaft and the piezoelectric ceramic actuator expands in the direction of the edge thereof such that the dome shape becomes thin, differential elements around the vibration shaft are subjected to compressive forces from adjacent differential elements and resultant force of these compressive forces is applied to a protruding direction of the shaft, so that the apex portion of the piezoelectric ceramic actuator is finally protruded. Here, it can be seen that the differential elements are arranged in a ring shape towards the center of the vibration shaft.

On the contrary, when the piezoelectric ceramic actuator constituting the piezoelectric ceramic motor expands towards the vibration shaft while contracting towards the edge thereof such that the dome shape becomes thick, the differential elements around the vibration shaft are subjected to forces opposite to the aforementioned case and resultant forc e of these forces is applied to an opposite direction to the protruding direction of the shaft, so that the apex portion of the piezoelectric ceramic actuator is depressed.

Here, when FEM simulation was carried out under the condition that the dome-shaped piezoelectric ceramic actuator had a diameter of 9.86 mm, a curvature of 4.6 mm and a thickness of 0.4 mm and was made of PZT 5A as a piezoelectric material, results could be obtained using piezoelectric, dielectric and elastic constants of the following Table 1.

**Table 1**

| S₁₁^{E} | S₁₂^{E} | S₁₃^{E} | S₃₃^{E} | S₄₄^{E} |
|---|---|---|---|---|
| 16.4*10⁻¹²m²/N | -5.74*10⁻¹²m²/N | -7.22*10⁻¹²m²/N | 18.8*10⁻¹²m²/N | 47.5*10⁻¹²m²/N |
| d₁₅ | d₃₁ | d₃₃ | ε₁₁ ^{T}/ε⁰ | E₁₁ ^{T}/ε⁰ |
| 584*10⁻¹²C/N | -171*10⁻¹²C/N | 374*10⁻¹²C/N | 1730 | 1700 |

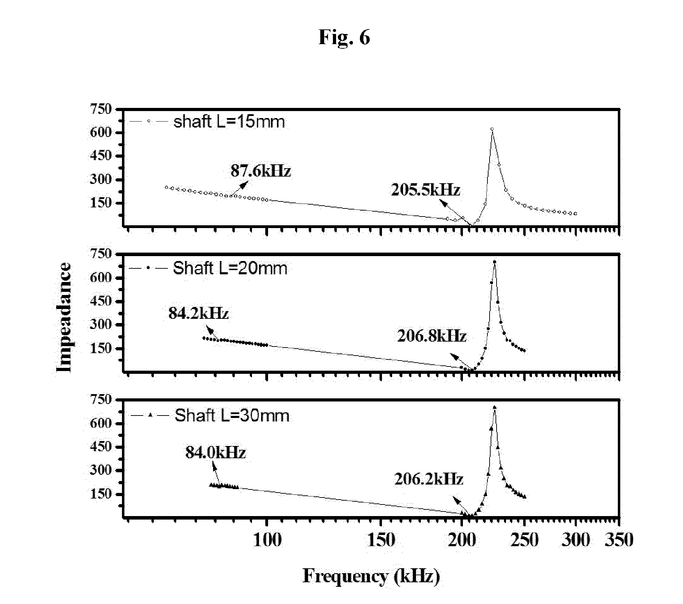

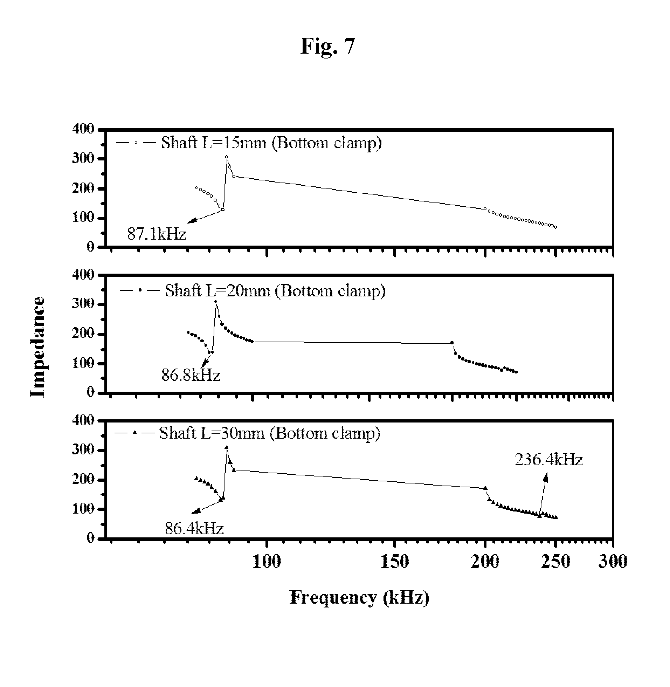

Fig. 6 is a simulation graph of an impedance-frequency curve of a dome-shaped piezoelectric linear motor (DSPLM) according to a comparative example, and Fig. 7 is a simulation graph of an impedance-frequency curve of a dome-shaped piezoelectric linear motor (DSPLM) according to one embodiment of the present invention.

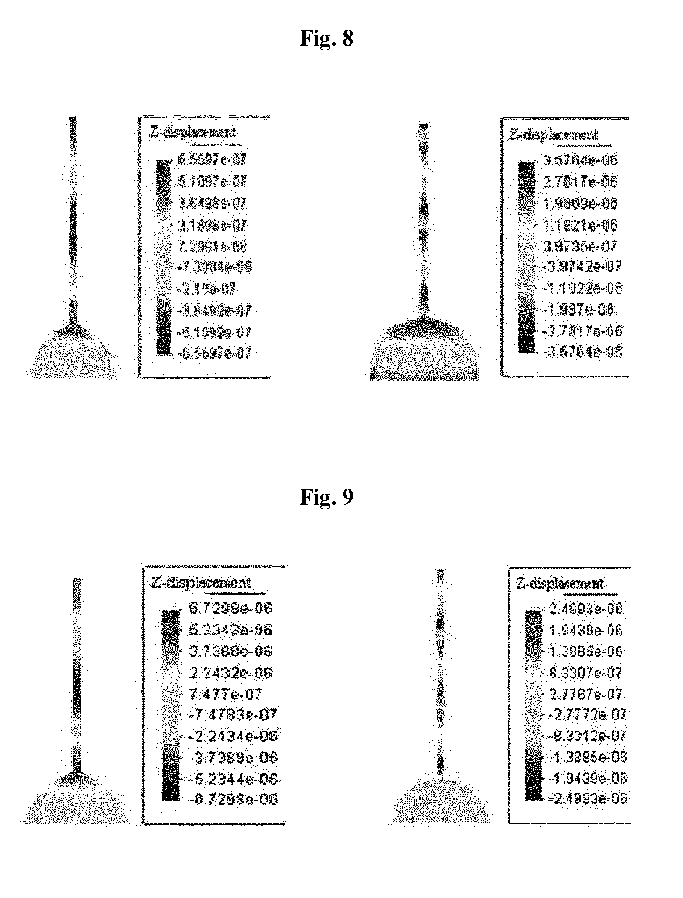

Fig. 8 shows results of ATILA three-dimensional simulation upon application of resonance frequency to the dome-shaped piezoelectric linear motor (DSPLM) according to the comparative example, and Fig. 9 shows results of ATILA three-dimensional simulation upon application of resonance frequency to the dome-shaped piezoelectric linear motor (DSPLM) according to the embodiment of the present invention.

In the above case, the simulation was carried out under the assumption that there is no other condition with respect to the piezoelectric ceramic actuator, and the results can be seen from Fig. 6 and Fig. 8, and the simulation results after mounting the restraining element can be seen from Fig. 7 and Fig. 9.

Fig. 6 is an impedance-frequency curve obtained for vibration shafts having lengths of 15 mm, 20 mm, and 30 mm, in which impedance variation appears substantially at two portions, that is, a first vibration displacement portion at 84.0 to 87.6kHz and a second vibration displacement portion at 205.5 to 206.8kHz. In Fig. 8, it can be seen that the first vibration displacement portion corresponds to vibration displacement with respect to the Z-axis and the second vibration displacement portion corresponds to vibration displacement in the radial direction.

It can be seen that the vibration displacement with respect to the Z-axis is ±0.657µm, and the vibration displacement in the radial direction is ±3.576µm upon application of a voltage of 70Vₚ₋ₚ. Namely, when the restraining element is not provided to the edge of the dome-shaped piezoelectric ceramic actuator, the vibration displacement by the radial vibration mode is greater than the vibration displacement in the direction of the vibration shaft.

In the embodiment of Fig. 7 and Fig. 9, the piezoelectric motor is provided at a lower portion thereof with the restraining element, so that the vibration displacement with respect to the Z-axis is ±6.72µm, thereby providing an effect of expanding vibration displacement. Further, the vibration displacement in the radial direction is ±2.499µm, which is similar to the vibration displacement with respect to the Z-axis as shown in Fig. 6. Thus, it can be seen that the dome-shaped piezoelectric linear motor including the retaining element according to the embodiment has generally improved vibration displacement (vibration displacement in the direction of the vibration shaft and vibration displacement in the radial direction) upon application of the same voltage.

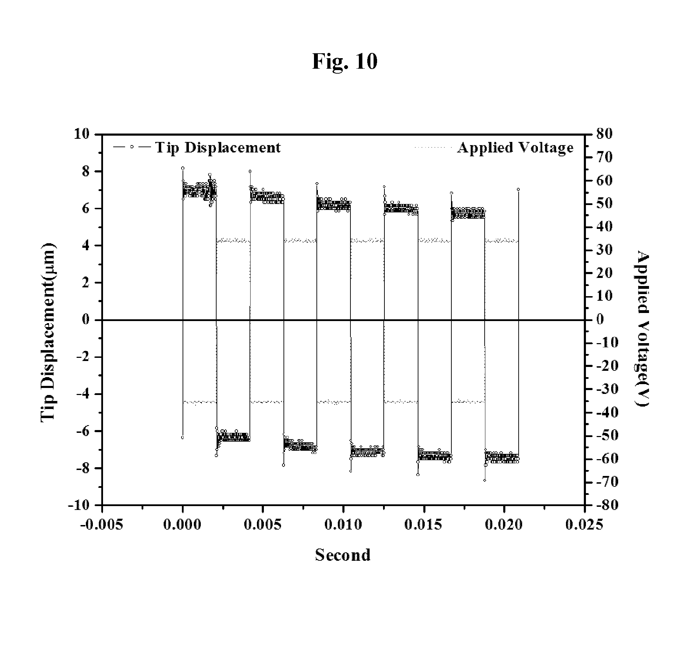

Fig. 10 is a graph depicting maximum vibration and application voltage for one example of a dome-shaped piezoelectric linear motor (DSPLM) according to the present invention.

Fig. 10 shows test results with respect to one inventive example of a dome-shaped piezoelectric ceramic actuator manufactured using soft PZT having a composition of 0.04Pb(Sb₀.₅Nb_{0.5})O₃-0.46PbTiO₃-0.5PbZrO₃ by powder injection molding (PIM). For this test, the dielectric constant at room temperature was set to d₃₃∼550pC/N, piezoelectric characteristics were set to k₃₃ ^{T}∼1450 and kₚ=0.7, Curie Temperature Tc was set to 320, and the dome-shaped piezoelectric ceramic actuator had a diameter of 9.86 mm, a curvature of 4.53 mm and a thickness of 0.4 mm.

First, in order to measure electrochemical properties, a sintered sample was prepared by grinding silver pastes (Metech Inc., #3288) sintered at 650°C for 30 minutes and forming electrodes using the silver pastes. Then, the sample was dipped into an oil bath at 150°C, followed by application of a DC voltage of 2.5 kV/mm for 40 minutes. Then, the vibration shaft was bonded to the apex of the dome-shaped piezoelectric ceramic actuator.

Next, in order to compare the test results with the simulation results of Fig. 6 to Fig. 9, the first vibration displacement portion was measured using a micro laser interferometer (Cannon, DS-80A) having a resolving power of 0.08 nm in terms of electrochemical variation characteristics of the piezoelectric ceramic actuator according to the present invention. From measurement results, it could be seen that a square wave electric field was applied to the sample and a bipolar wave electric filed was applied thereto at 50 kHz.

As described above, although the dome-shaped piezoelectric ceramic actuator according to the present invention prepared through the PIM process has a small size, it exhibits a large tip vibration displacement of 7.84 µm. At this time, a low electric field was 87.5 Vₒ₋ₚ/mm, and this result was obtained through FEM analysis. Thus, the dome-shaped piezoelectric linear motor according to the present invention manufactured through the PIM process exhibits excellent vibration displacement at low voltage.

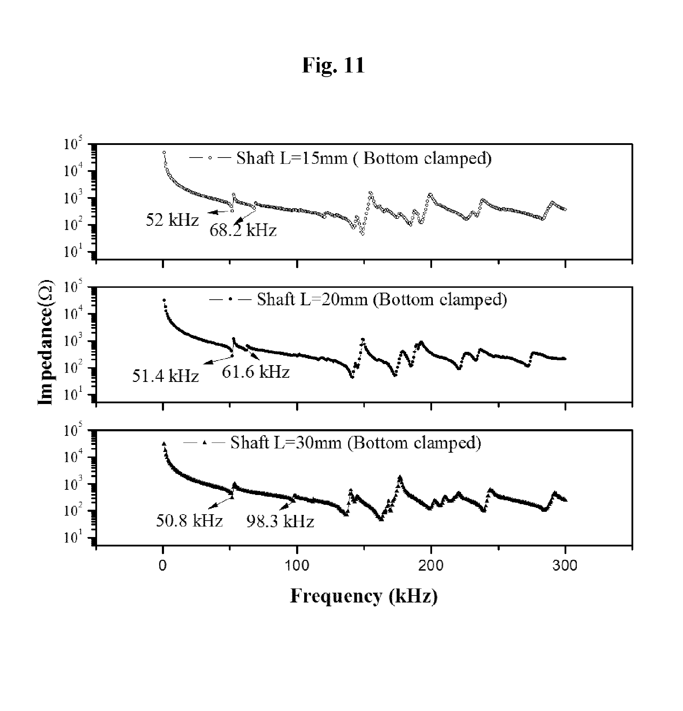

Fig. 11 is a simulation graph of an impedance-frequency curve of another example of a dome-shaped piezoelectric linear motor (DSPLM) according to the present invention.

Referring to Fig. 11, there is shown a simulation result for the impedance-frequency curve as obtained using an HP4194A. From this simulation result and test data, it can be seen that the vibration displacement with respect to the Z-axis appears at two portions in the range of 50 to 100 kHz.

Here, although the first resonance frequency range is similar to that of a general simulation result, the restraining element of the motor according to the present invention provides various types of resonance frequency curves. In this case, it is possible to obtain displacement variation in various vibration modes with respect to the Z-axis while improving efficiency thereof.

The dome-shaped piezoelectric linear motor according to the present invention provides not only excellent vibration displacement, but also stable displacement of the mobile element. Next, operation of the piezoelectric linear motor based on association of the vibration shaft with the mobile element will be described in more detail.

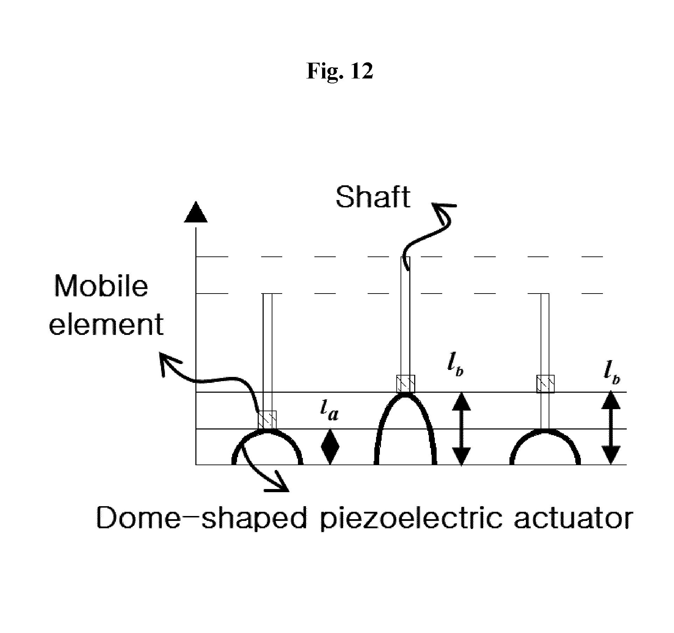

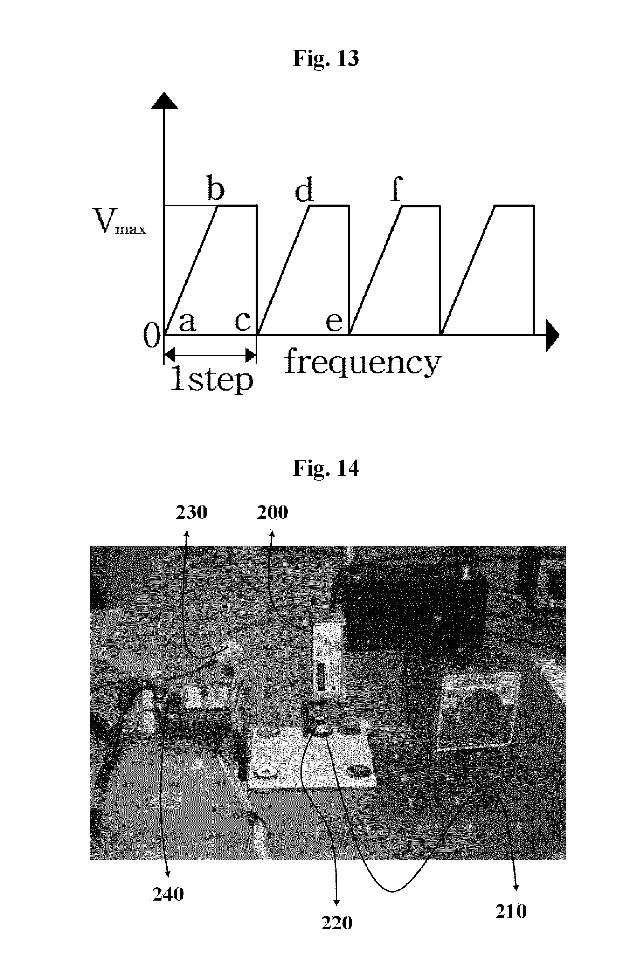

Fig. 12 is a graph depicting variation of a mobile element according to the inertial principle of a dome-shaped piezoelectric linear motor (DSPLM) according to one embodiment of the present invention, and Fig. 13 is a graph depicting electrical potential according to the variation of Fig. 12.

As can be seen from Fig. 3, the vibration shaft is secured to one surface of the piezoelectric ceramic actuator so as to be associated with displacement of the actuator. Since one side of the piezoelectric ceramic actuator typically faces a frame or housing of the motor, the vibration shaft is secured to the other side of the piezoelectric ceramic actuator.

Here, the mobile element is linearly driven by friction with the vibration shaft while being in contact with the vibration shaft. Thus, a contact region between the mobile element and the vibration shaft is provided with a compressing member, such as a spring, a bolt, a silicon rubber member, and the like, to maintain a predetermined degree of friction therebetween.

In the case in which the vibration shaft connected to the mobile element is moved due to vibration of the piezoelectric ceramic actuator, the mobile element is moved in the moving direction of the vibration shaft, if inertia of the mobile element is less than friction between the mobile element and the vibration shaft. If inertia of the mobile element is not less than friction therebetween, the mobile element remains still and only the vibration shaft is moved.

Here, a saw tooth wave drive voltage is applied to the piezoelectric linear motor, as shown in Fig. 13.

When the saw tooth wave drive voltage is applied to the piezoelectric ceramic actuator, the vibration shaft of the piezoelectric ceramic actuator moves at a relatively slow rate in the protruding direction in a section in which the voltage slowly varies (a->b, c->d, e->f) (Section A), and thus friction between the vibration shaft and the mobile element increases above inertia of the mobile element, allowing the vibration shaft and the mobile element to move together (1a->1b).

On the contrary, in a section in which the voltage rapidly varies (b->c, d->e) (Section B), the vibration shaft of the piezoelectric ceramic actuator moves at a relatively fast rate in the opposite direction to the protruding direction, and thus inertia of the mobile element becomes greater than friction between the vibration shaft and the mobile element, so that the mobile element slides on the vibration shaft, thereby allowing movement of the vibration shaft only (1b).

Consequently, as the Section A and the Section B are repeated, the vibration displacement of the mobile element is accumulated, so that the mobile element is moved in the protruding direction. When voltage having a phase difference of 180 degrees from the saw tooth wave of Fig. 13 is applied to the actuator, the vibration displacement of the mobile element is accumulated in the opposite direction to the protruding direction, so that the mobile element is moved in the opposite direction to the protruding direction.

The piezoelectric linear motor according to the embodiment further includes the restraining element, which supports the piezoelectric ceramic actuator while restraining displacement of the piezoelectric ceramic actuator in the direction of the edge thereof to a certain degree, thereby allowing further improvement of axial displacement at the center of the piezoelectric ceramic actuator.

Fig. 14 shows an apparatus for measuring constant displacement with respect to one example of the dome-shaped piezoelectric linear motor (DSPLM) according to the present invention.

Referring to Fig. 14, with one example of a dome-shaped piezoelectric linear motor (DSPLM) 210 according to the present invention placed below a micro laser interferometer (Cannon, DS-80A) 200 having a resolving power of 0.08 nm, a laser beam reflector and a load were mounted on mobile element 220.

In addition, the piezoelectric ceramic actuator of the linear motor was connected to a voltage probe 230, which was connected to a driving circuit or I.C. 240 for voltage application.

Here, a weight of 10 g or less was used as the load, a voltage of 60 Vp-p was applied at a resonance frequency of 50 kHz, and displacement was measured using 5 pulses.

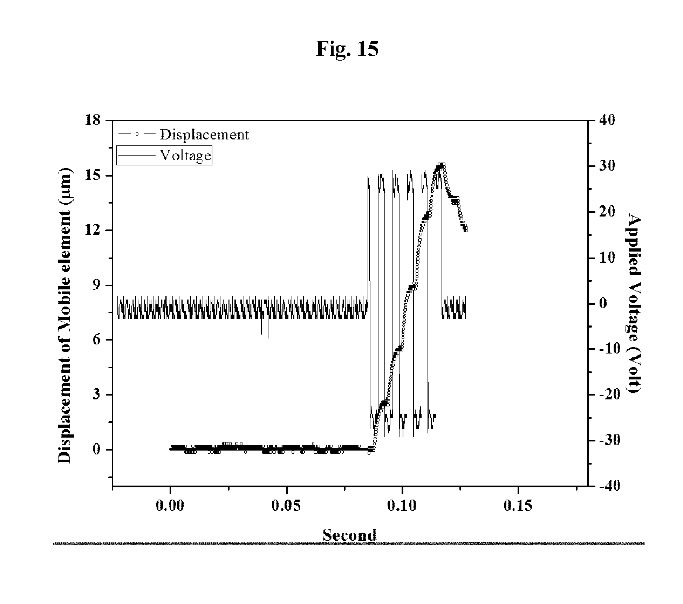

Fig. 15 is a graph depicting total variation upon application of resonance frequency to the one example of the dome-shaped piezoelectric linear motor (DSPLM) according to the embodiment of the present invention.

Referring to Fig. 15, the total displacement was 15.6µm when measured using the device of Fig. 14. Here, since the device is used for 5 pulses, controllable displacement of the dome-shaped piezoelectric linear motor according to the present invention becomes 3.15 µm.

As described above, it can be confirmed that the piezoelectric linear motor including the dome-shaped piezoelectric ceramic piezoelectric actuator and the restraining element may exhibit a maximum tip displacement of the dome shape up to 7.48 µm and a constant average displacement of 4.12 µm as the electric field increases, thereby exhibiting substantially superior properties to a disc-shaped piezoelectric linear motor.

Although some embodiments have been described herein, it should be understood by those skilled in the art that these embodiments are given by way of illustration only, and that various modifications, variations, and alterations can be made without departing from the spirit and scope of the invention. Therefore, the scope of the invention should be limited only by the accompanying claims and equivalents thereof.

## Claims

1. A dome-shaped piezoelectric linear motor (DSPLM) comprising:
a dome-shaped piezoelectric ceramic actuator having opposite sides to which different electrodes are applied;
a bar-shaped vibration shaft vertically secured to an apex of the dome-shaped piezoelectric ceramic actuator;
a cylindrical mobile element inserted into the vibration shaft and linearly moving along the vibration shaft; and
a ceramic restraining element secured to a lower edge of the dome-shaped piezoelectric ceramic actuator.

2. The piezoelectric linear motor of claim 1, further comprising:
a compressing member disposed on the mobile element to maintain a predetermined degree of friction in a contact region between the mobile element and the vibration shaft.

3. The piezoelectric linear motor of claim 2, wherein the compressing member is one selected from among a spring, a bolt and a silicon rubber member.

4. The piezoelectric linear motor of claim 1, wherein the ceramic restraining element is integrally formed with the dome-shaped piezoelectric ceramic actuator.

5. The piezoelectric linear motor of claim 1, wherein the ceramic restraining element is formed of a material having rigidity capable of restraining radial vibration of the piezoelectric ceramic actuator and having a similar coefficient of thermal expansion to the piezoelectric ceramic actuator.

6. The piezoelectric linear motor of claim 1, wherein the ceramic restraining element has a disk shape or a ring shape.

7. The piezoelectric linear motor of claim 1, wherein the ceramic restraining element is coupled to the piezoelectric ceramic actuator via a thermosetting bonding agent.

8. The piezoelectric linear motor of claim 1, further comprising:
a power source for applying voltage to the piezoelectric ceramic actuator;
an electric wire connecting the power source to opposite sides of the piezoelectric ceramic actuator; and
solders securing the electric wire to the opposite sides of the piezoelectric ceramic actuator.

9. The piezoelectric linear motor of claim 1, wherein the piezoelectric ceramic actuator is manufactured using a composition of 0.04Pb(Sb_{0.5}Nb_{0.5})O₃-0.46PbTiO₃-0.5PbZrO₃.

10. The piezoelectric linear motor of claim 1, wherein the piezoelectric ceramic actuator is manufactured by powder injection molding (PIM).
